# EUROPEAN PATENT APPLICATION

(11) **EP 1 335 640 A2**
(43) Date of publication of application: **13.08.2003**
(21) Application number: 03002336.0
(22) Date of filing: 03.02.2003
(51) Int. Cl.: H05G 2/00

(54) **Plasma-type X-ray source encased in vacuum chamber exhibiting reduced heating of interior components, and microlithography systems comprising same**

(30) Priority: 04.02.2002 JP 2002026540
(71) Applicant: NIKON CORPORATION, Tokyo 100-0005 (JP)
(72) Inventor: Kondo, Hiroyuki, Kanagawa (JP)
(74) Representative: Meddle, Alan Leonard

(57) **Abstract**

X-ray generators that produce X-ray radiation from a plasma and that exhibit reduced heating of certain components caused by proximity to the plasma. An embodiment of such an X-ray generator is encased in a vacuum chamber that exhibits reduced reflection and scattering of electromagnetic radiation from the inner walls thereof to components contained in the chamber. Since less reflected radiation reaches the components, the components experience less temperature increase during use. For example, the inner walls can be coated with a film of carbon black that absorbs incident radiation from infrared to ultraviolet.

## Description

### Field

This disclosure pertains to X-ray generators suitable for use as exposure-light sources in, for example, X-ray microlithography systems, and to X-ray microlithography systems comprising the same. More specifically, the disclosure pertains to X-ray generators that produce X-rays from a plasma and that exhibit decreased reflection and scattering from the inner walls of a chamber containing the plasma, thereby reducing temperature increases of components contained in the chamber.

### Background

As the diffraction-limitations of optical microlithography (*i.e.*, microlithography performed using a deep-ultraviolet light beam as a lithographic energy beam) have become increasingly burdensome, substantial effort currently has been expended to develop a practical "next-generation lithography" (NGL) system. An especially promising approach involves the use of certain X-ray wavelengths as the lithographic energy beam. In this regard, substantial progress has been made in the use of "soft X-ray" ("SXR") wavelengths (also termed "extreme UV" or "EUV" wavelengths), typically in the range of approximately 10 to 15 nm. Part of this effort has been directed to the development of an acceptable EUV-beam source.

Two types of X-ray sources that show exceptional promise are the so-called "laser-plasma" sources and "discharge-plasma" sources. These sources are especially useful not only for EUV microlithography systems and other EUV-exposure systems, but also in various X-ray-analysis devices. In a laser-plasma X-ray ("LPX") source a plasma is generated by directing a focused pulsed laser light on a target material inside a vacuum chamber. The target material is highly excited by the pulsed laser light, and X-rays are emitted from the plasma as atoms in the plasma transition to lower energy states. LPX sources are compact and produce X-rays having a brightness rivaling the brightness of X-rays produced by an undulator (synchrotron).

Discharge-plasma X-ray ("DPX") sources produce an X-ray-generating plasma by an electrical discharge in the presence of a target material. These sources include "dense plasma focus" (DPF) sources, in which a high-voltage pulse is impressed on electrodes to produce an electrical discharge. The discharge ionizes a working gas (constituting the target material) and generates therefrom a plasma that emits X-rays. DPX sources are compact and low-cost, and produce a high emission yield of X-rays. Other types of DPX sources include hollow-cathode and capillary sources.

LPX and DPX sources have found particular utility recently as EUV-light sources as used in "reducing" (demagnifying) projection-microlithography systems, especially such systems utilizing a 13-nm EUV beam as the lithographic energy beam. As a result of these and other seminal developments, EUV microlithography is a most promising NGL technology on the threshold of reaching practicality for use in the fabrication of microelectronic devices such as semiconductor integrated circuits, memory devices, and displays.

Since no known materials exist that can adequately refract EUV radiation. EUV-optical systems must be constructed of reflective optical elements, notably multilayer-film mirrors that exhibit high (currently approximately 70%) reflectivity of incident EUV radiation at perpendicular incidence. For example, for EUV radiation having λ = 13 nm, a suitable multilayer film comprises multiple Mo/Si layer pairs (*e.g.*, 45 layer pairs), in which multilayer film the Mo layers are laminated in an alternating manner with the Si layers. The reflection bandwidth (BW) of this type of mirror is approximately ±1 %; hence, assuming a median wavelength of 13.5 nm, the bandwidth of reflected EUV light from the multilayer-film mirror is 13.365 nm to 13.635 nm. With this mirror EUV light outside this reflection bandwidth does not contribute to lithographic imaging (pattern-transfer).

The various plasma X-ray sources discussed above do not exhibit a high conversion efficiency of EUV light relative to input power, especially with respect to the reflection bandwidth of multilayer-film mirrors. For example, with an LPX source in which Xe gas is the target material, the conversion efficiency with which 13-nm EUV light (at 2% BW, emitted at a solid angle of 2π sr) is produced is approximately 0.6 %.

EUV light incident to the illumination-optical system of an EUV microlithography system currenuy must be at least approximately 50W to achieve acceptable throughput This intensity requires that the incident laser light have a power of 15 kW, wherein the solid angle of EUV light from the plasma is π sr. As hinted above, most of the power of the incident laser light is absorbed by the plasma. Also, up to several tens of percent of the incident laser power is consumed as work expended in converting the target material into a plasma. In addition, some of the incident laser power is scattered by the plasma and target material. The remaining power radiates away from the plasma in a broad wavelength range from infrared to X-ray.

Immediately downstream of the plasma X-ray source is an illumination-optical system, of which the first mirror (referred to as mirror "C1") typically is configured to gather as much as possible of the EUV light emitted from the plasma X-ray source. Also, the mirror C1 desirably is made as small as possible so as to simplify fabrication of the mirror. Consequently, the mirror C1 is disposed in the vicinity of the plasma (*e.g.*, at a distance of 10 to 20 cm from the plasma). If the reflectivity of the multilayer film of the mirror C1 is approximately 70%, then approximately 15 W of the 50 W of in-band EUV power incident to the mirror C1 is absorbed by the multilayer film of the mirror C1. Most of the broad-bandwidth radiation (infrared to X-ray) outside the reflection bandwidth of the multilayer film is absorbed by the multilayer-film mirror C1.

Absorption of energy, as described above, by the mirror C1 increases the temperature of the mirror's multilayer film and mirror substrate. As the temperature of the multilayer film is increased in this manner, substantial diffusion occurs at the boundary interfaces between respective individual layers of the multilayer film (*e.g.*, between adjacent Mo and Si layers). Such diffusion decreases the reflectivity of the multilayer film to incident EUV light.

For example, consider an instance in which the temperature of the multilayer film, disposed 15 cm from the plasma and with an incident laser power of 10 kW, increases to several hundreds of degrees C. If the multilayer film is a Mo/Si multilayer film, boundary diffusion occurs at a marked rate whenever the temperature of the Mo/Si multilayer film exceeds approximately 300 °C. Even if the multilayer film does not reach 300 °C, if the elevated temperature persists for a sufficiently long period of time, depending upon the circumstances, sufficient boundary diffusion may occur in the Mo/Si multilayer film to significantly reduce its reflectivity and thus shorten the useful life of the mirror.

The foregoing description highlights the temperature increase of the multilayer-film mirror arising from radiation from the plasma that is directly incident to the mirror. But, under actual conditions, the temperature of the multilayer-film mirror is increased even further as a result of heating caused by indirect radiation from the plasma.

Plasma X-ray sources, including LPX and DPX sources, must be operated in a vacuum environment in order to generate a plasma and to facilitate propagation of EUV light from the plasma. Consequently, the target material and any discharge electrodes of the source must be connected from outside to inside the vacuum chamber enclosing the source. The vacuum chamber also contains the multilayer-film mirror C1. Conventional plasma X-ray sources are contained in respective vacuum chambers made of either stainless steel or aluminum. To facilitate evacuation of the chamber to a high vacuum, the inner surfaces of such chambers have either a metallic luster, without any surficial treatment, or a mirror finish achieved by electrolytic polishing or the like. Infrared through ultraviolet wavelengths of radiation emitted from the plasma are reflected from or scattered by the inner surfaces of the chamber to the mirror C1. This "indirect" irradiation of the mirror C1 contributes to excessive heating of the mirror.

In addition to the multilayer-film mirror C1, other components disposed inside the vacuum chamber include a target-material-discharge member (*e.g.*, a gas-jet nozzle in the case of a Xe-gas-jet LPX), discharge electrodes (for DPX sources), and one or more filters. The filters are used for blocking downstream propagation of infrared, visible, and UV light and transmitting EUV radiation emitted from the plasma. If these wavelengths were not blocked, they would interfere downstream with the transfer-exposure of fine pattern elements. Hence, the filters transmit only the required wavelength range of EUV light. Since common materials readily absorb EUV light, the filters typically are extremely thin, *e.g.*, approximately 150 nm thick. Such thin filters are prone to fracture if an excessive thermal load is imposed on the filter.

Excessive heating of various components located inside the vacuum chamber, as described above, decreases their performance. For example, the temperature of the gas-jet nozzle used for discharging a stream of Xe target material must be kept low to ensure efficient production by the nozzle of clusters of solid or liquid Xe. It also is necessary to prevent excessive temperature increases of discharge electrodes caused by heat radiating from sources other than the electrical current normally applied to the electrodes, so as to avoid melting the discharge electrodes.

### Summary

In view of the foregoing, the present invention provides, inter *alia*, X-ray generators exhibiting reduced reflection and scattering of radiation from the inner walls of a chamber containing the plasma, thereby reducing the operational temperature of components located inside the chamber, and lengthening the useful life of the components.

According to a first aspect of the invention, X-ray generators arc provided. An embodiment of the X-ray generator comprises an X-ray source and a vacuum chamber. The X-ray source produces a plasma, from a target material, that emits X-rays. The vacuum chamber is defined by walls and contains the X-ray source. The walls include respective inner surfaces that are configured so that at least a portion of the inner surfaces absorbs incident electromagnetic radiation, produced by the plasma, in a wavelength range from infrared to X-ray radiation. The portion represents a location from which the electromagnetic radiation otherwise would reflect back into the vacuum chamber and heat a component situated inside the vacuum chamber.

The X-ray source can be, for example, a laser-plasma X-ray source or a discharge-plasma X-ray source.

By way of example, to confer high reflectivity to the incident electromagnetic radiation, the portion of the inner surfaces can be coated with carbon. The carbon can be selected from the group consisting of carbon black, benzene soot, fullerene, carbon nanotubes, and dried suspensions of colloidal graphite.

By way of another example, the portion of the inner surfaces can comprise a porous material, such as activated charcoal or porous silicon.

By way of yet another example, the portion of the inner surfaces can be anodized or comprise a unit of anodized aluminum.

By way of yet another example, the portion of the inner surfaces can comprise a "brushy" layer comprising, *e.g.*, multiple needle-shaped members, bristle-shaped members, or blade-shaped members. Desirably, these members extend from the inner wall toward the plasma. The needles desirably have respective tapered tips extending toward the plasma. Alternatively, the brushy layer Is configured as a "carpet" of glass fibers or bristles, carbon fibers or bristles, metal fibers or bristles, or silicon fibers or bristles, or combinations thereof.

An X-ray generator according to another embodiment comprises an X-ray source as summarized above and a vacuum chamber defined by walls and containing the X-ray source. At least a portion of the walls is made of a material that is transmissive to incident electromagnetic radiation, from the plasma, in a wavelength range from infrared to ultraviolet. The portion represents a location from which the electromagnetic radiation otherwise would reflect back into the vacuum chamber and heat a component situated inside the vacuum chamber. The portion can be made of a glass material such as, but not necessarily limited to, conventional glass, quartz glass. MgF₂, and CaF₂. The portion can include an anti-reflective coating applied to the glass material.

According to another aspect of the invention, X-ray microlithography systems are provided. An embodiment of such a system comprises any of the X-ray generators summarized above. The system also includes an illumination-optical system situated and configured to direct an X-ray illumination beam from the X-ray generator onto a pattern-defining reticle, thereby forming a patterned beam carrying an aerial image of the pattern. The system also includes a projection-optical system situated and configured to project the patterned beam from the reticle to form an image on a sensitive substrate.

The foregoing and additional features and advantages of the invention will be more readily apparent from the following detailed description, which proceeds with reference to the accompanying drawings.

### Brief Description of the Drawings

FIG. 1 is a schematic elevational section of an X-ray generator according to a first representative embodiment.
FIG. 2 is a schematic elevational section of an X-ray generator according to a second representative embodiment.
FIG. 3 is an enlargement of detail of several of the needle-shaped members in the brushy layer lining the inner walls of the vacuum chamber of the X-ray generator of FIG. 2.
FIG. 4 is a schematic elevational section of an X-ray generator according to a third representative embodiment.
FIG. 5 is a schematic elevational diagram of a representative embodiment of a microlithography system including, by way of example, the X-ray generator of FIG. 2.

### Detailed Description

The invention is described below in the context of representative embodiments that are not intended to be limiting in any way. Although each of the various embodiments comprises a laser-plasma X-ray source, it will be understood that any of various other plasma X-ray sources can be used. Also, even though certain positional relationships (*e.g.*, "top," "bottom," "left," "right," "upper," and "lower") are shown in the figures, it will be understood that these relationships are not intended to be limiting unless specifically stated otherwise.

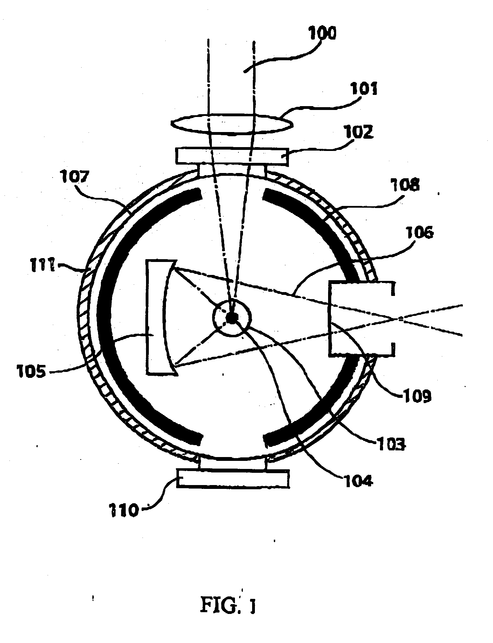

A first representative embodiment of an X-ray generator is depicted in FIG. 1. The X-ray generator comprises a vacuum chamber 107 that is connected in a conventional manner to a vacuum pump (not shown) that evacuates the atmosphere inside the vacuum chamber 107 to a vacuum level of several Torr or less. By imposing such a vacuum level inside the vacuum chamber 107, pulsed laser light 100 can propagate to the target material without being absorbed and/or attenuated by air, and X-ray radiation produced by the plasma 104 will not be damped significantly by absorption.

The vacuum chamber 107 includes a first window 102 made of glass or other material transmissive to the laser light 100. A lens 101 is disposed outside the window 102. Pulsed laser light 100 emitted from a laser (not shown) is focused by the lens 101 through the window 102 on the target material, which produces a plasma 104. X-rays arc emitted from the plasma 104. Laser light not absorbed by the plasma is transmitted through a second window 110 to outside of the vacuum chamber 107. Hence, most of the laser light does not strike the inner walls of the vacuum chamber 107 and hence does not contribute to heating of the inside of the vacuum chamber 107.

The target material in this embodiment is Xe gas discharged at ultrasonic velocity from a gas-jet nozzle 103. The gas-jet nozzle 103 is disposed so that it discharges the Xe gas in a direction perpendicular to the plane of the page on which FIG. 1 is drawn. After being used to produce the plasma, spent Xe gas discharged from the gas-jet nozzle 103 is evacuated from the vacuum chamber 107 by a vacuum pump (not shown).

A multilayer-film, ellipsoidal focusing mirror 105 is disposed near the plasma 104. The reflective surface of the focusing mirror 105 is coated with multiple alternating layers of Mo and Si to form a multilayer-film interference coating. The multilayer film is configured so as to be highly reflective to incident EUV radiation having a wavelength of λ = 13.4 nm. The period length of the multilayer film is changed as required over the reflective surface so as to achieve maximal EUV reflectivity at all points on the reflective surface.

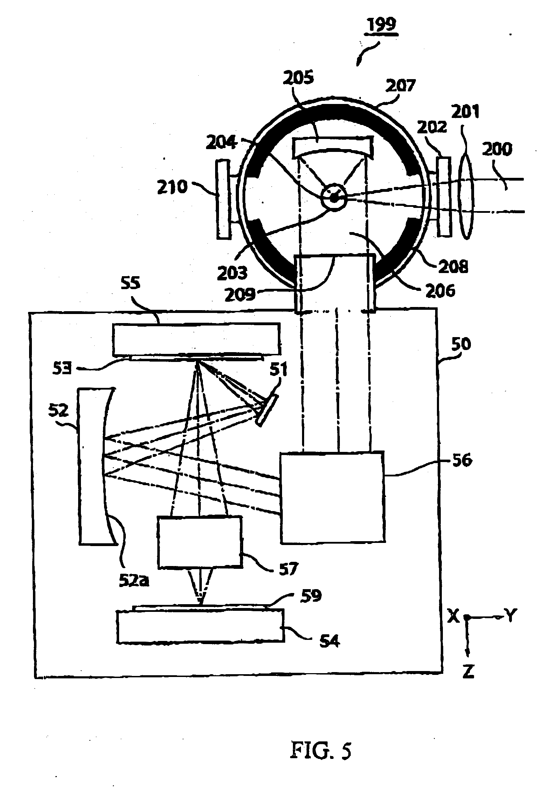

The rear of the focusing mirror 105 is cooled by a cooling mechanism (not shown but well understood in the art). EUV light 106 reflected by the mirror 105 passes through a filter 109 that blocks infrared, visible, and ultraviolet light and transmits EUV radiation of a particular wavelength. EUV radiation passing through the filter enters a downstream illumination-optical system (not shown, but see FIG. 5, discussed later below). The infrared, visible, and ultraviolet wavelengths that are blocked by the filter 109 are generated by the plasma 104 but otherwise would adversely affect the resolution of fine pattern elements. Hence, the filter 109 only transmits the required wavelength of EUV light.

In the embodiment of FIG. 1, the inner walls of the vacuum chamber 107 are lined with a film 108 of carbon black. Carbon black is highly absorptive to electromagnetic radiation in the range from infrared to X-ray. "Highly absorptive" in this context means that the subject material absorbs at least 90% of the incident radiation in the range of infrared through ultraviolet. (Absorption of untreated metals to these wavelengths typically is less than several percent.) Consequently, the carbon black film 108 prevents components such as the mirror 105 from being heated by reflected and/or scattered infrared to X-ray radiation from the inner walls of the vacuum chamber 107.

Since radiation from the plasma is absorbed at the inner walls by the carbon black coating 108, the temperature of the walls of the vacuum chamber 107 will experience an increase. If it is necessary to remove this heat, a cooling jacket 111 can be fitted to the exterior, for example, of the vacuum chamber 107.

Various materials, other than carbon black, that are highly absorptive to electromagnetic radiation ranging from infrared to X-ray alternatively can be used. Exemplary alternative materials include benzene soot, fullerenc, carbon nanotubes, and Aquadag® (an aqueous colloidal suspension of graphite made by, *e.g.*, Macalaster Bicknell). Benzene soot is a soot produced by burning benzene. Further alternatively, any of various porous materials may be used for absorbing incident electromagnetic radiation ranging from infrared to X-ray. Porous materials have innumerable microscopic holes in their surfaces. Light entering the holes is repeatedly reflected and scattered inside the holes by the inner walls of the holes, and thus is prevented from exiting the holes as reflected or scattered light. In other words, the holes behave as ideal black bodies for incident light ranging from infrared to X-ray. An exemplary porous material in this regard is activated charcoal.

The carbon black coating 108 can be formed by applying carbon black to the inner walls of the vacuum chamber 107. Alternatively, the inner walls themselves can be modified (without application of a substance to them) so as to confer to the inner walls a high absorptivity to electromagnetic radiation ranging from infrared to X-ray. For example, the inner walls of an aluminum vacuum chamber 107 can be blackened by anodizing or attaching a unit of anodized aluminum.

Further alternatively, plates or sheets of a material that is highly absorptive to electromagnetic radiation ranging from infrared to X-ray can be adhered to the inner walls of the vacuum chamber 107. For example, plates or sheets of carbon (as a representative black material) or plates or sheets of porous silicon (as a representative porous material) may be adhered conformably to the inner walls of the vacuum chamber 107.

If a porous material is used for lining the inner walls, as discussed above, a high vacuum inside the vacuum chamber 107 probably will not be attainable. However, no problem is posed by an inability to achieve high vacuum so long as the actually attainable vacuum level is sufficient for generating a plasma in the X-ray source and for propagating the EUV light 106 produced by the source. Generally, a vacuum level suitable for meeting these criteria is several tenths of a Torr to several Torr. This range is achievable in a chamber lined with a porous material.

Porous material (configured as, *e.g.*, sheets) can be applied or adhered to the entire surfaces of the inner walls of the vacuum chamber. Alternatively, the material can be applied or adhered only to those portions of the inner walls at which radiation from the plasma 104 will be incident, or from which heat-producing reflection will occur.

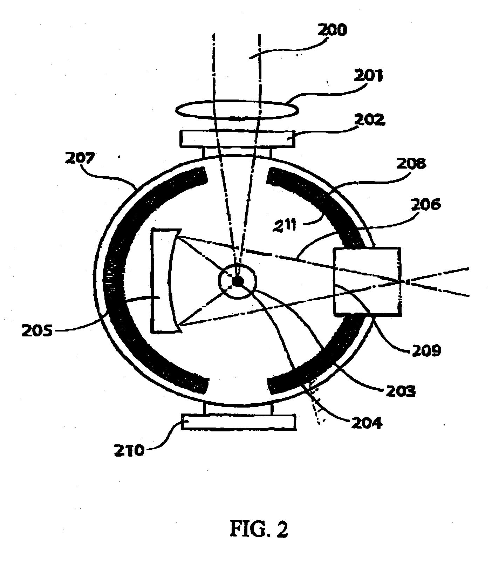

A second representative embodiment of an X-ray generator is depicted in FIG. 2. The depicted X-ray generator comprises a vacuum chamber 207, a lens 201 and first window 202 that pass a beam 200 of pulsed laser light, a gas-jet nozzle 203 at which a plasma 204 is formed, an ellipsoidal mirror 205 that produces a reflected beam 206, a filter 209 through which the reflected beam 206 passes, and a second window 210. These components are similar to corresponding components in the embodiment of FIG. 1. The X-ray generator of FIG. 2 differs from the embodiment of FIG. 1 mainly in that the embodiment of FIG. 2 comprises a brushy layer 208 of multiple needle-shaped members 211, rather than the film 108 in the FIG.-1 embodiment, disposed on the inside wall of the vacuum chamber 207. The tips of the needle-shaped members 211 desirably are oriented toward the plasma 204

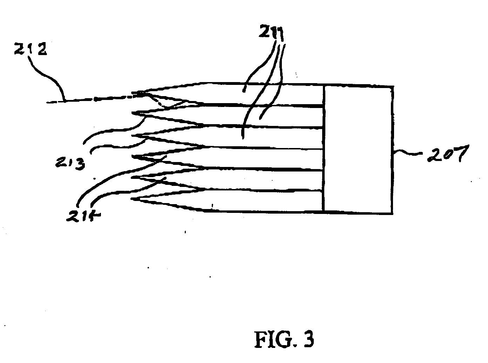

Enlarged detail of several needle-shaped members 211 is shown in FIG. 3. Light 212 radiating from the plasma 204 is incident on respective tapered surfaces 213 of tips 214 of the needle-shaped members 208, from which tapered surfaces the incident light is reflected multiple times toward the bulk mass of the brushy layer 208. The incident light ultimately is absorbed by the brushy layer 208, which can absorb light in a broad wavelength band ranging from infrared to X-ray. Thus, the brushy layer 208 behaves as a nearly ideal black body. The material used for fabricating the brushy layer 208 can be metal (*e.g.*, stainless steel or aluminum), glass, carbon, organic material (*e.g.*, organic polymer), or silane material (*e.g.*, silicone polymer).

The needle-shaped members 211 in FIGS. 2 and 3 appear in the figures as having sharp tips 214. This depicted configuration is not intended to be limiting because the tips of individual needle-shaped members 211 need not be "sharp" so long as the brushy layer 208 functions in the manner described above. As an alternative to "needle"-shaped configurations, the members 211 can be bristle-shaped or blade-shaped. For example, the brushy layer 208 can be a "carpet" of glass fibers, carbon fibers, metal fibers or bristles, or an array of blade-shaped members.

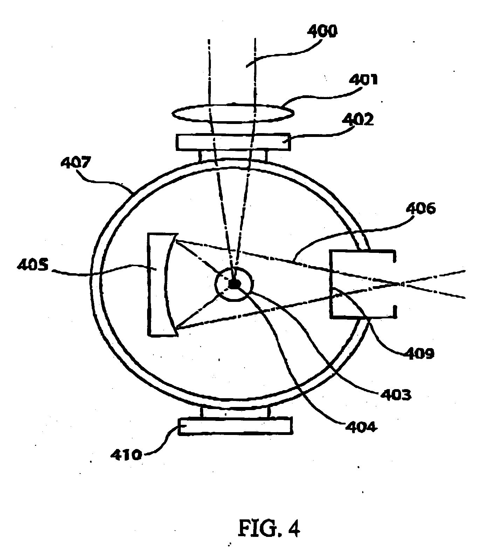

A third representative embodiment of an X-ray generator is depicted in FIG. 4. The depicted X-ray generator comprises a vacuum chamber 407, a lens 401 and first window 402 that pass a beam 400 of pulsed laser light, a gas-jet nozzle 403 at which a plasma 404 is formed, an ellipsoidal mirror 405 that produces a reflected beam 406, a filter 409 through which the reflected beam 406 passes, and a second window 410. These components are similar to corresponding components in the embodiments of FIGS. 1 and 2. The X-ray generator of FIG. 4 differs from the embodiment of FIG. I mainly in that the embodiment of FIG. 4 comprises a vacuum chamber 407 made of quartz glass. Quartz glass is highly transmissive to light in the range of infrared to ultraviolet. Consequently, by forming the vacuum chamber 407 of quartz glass, the light 406 readily passes through to outside the vacuum chamber 407 and hence is prevented from heating the components inside the vacuum chamber 407.

The vacuum chamber 407 can be made of a material, other than quartz glass, exhibiting high transmissivity to light in the range of infrared to ultraviolet. Exemplary materials in this regard are conventional glass, magnesium fluoride (MgF₂), and calcium fluoride (CaF₂).

The inner walls and/or the outer walls of the vacuum chamber 407 may be coated with an antireflective coating. Such a coating further decreases the amount of light 406 reflected from the walls of the chamber.

The vacuum chamber 407 may be made entirely of quartz glass. Alternatively, portions of the chamber requiring greater mechanical strength than provided by quartz glass may be formed of metal bonded to the quartz glass used for making the rest of the chamber.

In the embodiments described above, the respective X-ray generators were described as comprising laser-plasma X-ray (LPX) sources. It will be understood that individual X-ray generators alternatively can be another type of plasma X-ray source, such as a discharge-plasma X-ray source.

An embodiment of a microlithography system incorporating an X-ray generator 199 as described above is shown in FIG. 5. For convenience, without intending to be limiting in any way, the X-ray generator 199 included with the depicted system is configured according to the embodiment shown in FIG. 2.

In FIG. 5, the X-ray generator 199 is disposed on "top" of an exposure chamber 50. The exposure chamber 50 contains an illumination-optical system 56 that receives an EUV beam 206 reflected from the mirror 205 of the X-ray generator 199. The illumination-optical system 56 comprises one or more condenser mirrors and at least one fly-eye optical system (or analogous feature). The beam of EUV light reflected from the mirror 205, generally having a circular transverse profile, is directed as an "illumination beam" to the left (in the figure) by the illumination-optical system 56. In FIG. 5, only parallel rays of light propagating to the illumination-optical system 56 are shown. However, it will be understood that divergent and/or convergent rays of light also can propagate to the illumination-optical system 56. A vertically mounted reflective mirror 52 receives the illumination beam from the illumination-optical system 56. The mirror 52 is circular with a concave reflective surface 52a facing right in FIG. 5. Light of the illumination beam reflected from the mirror 52 is reflected by a light-path-bending mirror 51 toward a reflective reticle 53. The reticle 53 is horizontally mounted with its EUV-reflective surface facing downward in FIG. 5. The mirror 52 focuses the illumination beam, propagating from the illumination-optical system 56 and reflected by the mirror 51, onto the reflective surface of the reticle 53.

Each of the mirrors 51, 52 is made from a respective mirror substrate (*e.g.*, quartz) that has been finely machined to form an extremely accurate reflection surface (*e.g.*, item 52a in FIG. 5). Formed on each reflection surface is a respective multilayer-film coating (*e.g.*, a Mo/Si multilayer-film coating for reflecting EUV radiation of approximately 13-nm wavelength), which can be similar to the multilayer-film coating formed on the reflective surface of the mirror 205 in the X-ray generator 199. For other illumination-beam wavelengths in the range of 10 nm to 15 nm, the multilayer-film can be formed of other substances such as Ru or Rh as the "high-Z" layer and Si, Be, or B₄C as the "low-Z" layer.

A multilayer-film coating also is formed on the reflective surface of the reticle 53. Formed on the multilayer film of the reticle 53 is an "absorbing-body" layer that is patterned into individual absorbing bodies that, together with spaces between the absorbing bodies, define a reticle pattern to be transfer-exposed from the reticle 53 to a lithographic substrate 59 (*e.g.*, resist-coated semiconductor wafer). The reticle 53 is mounted to a reticle stage 55 that is movable in at least the Y direction. The illumination beam, shaped by the illumination-optical system 56 and reflected by the bending mirror 51, is illuminated on successive regions of the reticle 53 in a sequential manner, as effected by movements of the reticle stage 55. EUV light reflected from the reticle 53 constitutes a "patterned beam" that carries an aerial image of the pattern portion in the respective illuminated portion of the reticle 53.

The exposure chamber 50 also contains a projection-optical system 57 and the substrate 59 situated downstream of the reticle 53. The projection-optical system 57 comprises multiple mirrors that demagnify the aerial image carried by the patterned beam by a specified "reduction" factor (*e.g.*, 1/4) and form the corresponding actual image on the substrate 59. The substrate 59 is mounted to a substrate stage 54 that is movable in the X, Y, and Z directions.

During a microlithographic exposure using the system of FIG. 5, the illumination beam is directed by the illumination-optical system 56 onto the reflective surface of the reticle 53. Meanwhile, the reticle 53 and substrate 59 are synchronously moved in a scanning manner relative to each other and with respect to the projection-optical system 57 at a specified velocity ratio determined by the reduction factor of the projection-optical system. In this "step-and-scan" manner, the pattern defined on the reticle 53 is transferred to one or more respective dies on the substrate 59. Individual dies ("chips") on the substrate 59 have dimensions of, for example, 25 mm × 25 mm, and the pattern is formed on the substrate 59 with a line-and-space (L/S) resolution of at least 0.07 µm.

Whereas the invention has been described in connection with multiple representative embodiments, the invention is not limited to those embodiments. On the contrary, the invention is intended to encompass all modifications, alternatives, and equivalents as may be included within the spirit and scope of the invention, as defined by the appended claims.

In the present specification "comprises" means "includes or consists of" and "comprising" means "including or consisting of'.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. An X-ray generator, comprising:
an X-ray source in which a plasma is produced from a target material and X-rays are emitted from the plasma; and
a vacuum chamber defined by walls and containing the X-ray source, the walls including respective inner surfaces configured so that at least a portion of the inner surfaces absorbs incident electromagnetic radiation, produced by the plasma, in a wavelength range from infrared to X-ray radiation, the portion representing a location from which the electromagnetic radiation otherwise would reflect back into the vacuum chamber and heat a component situated inside the vacuum chamber.

2. An X-ray generator according to Claim 1, wherein the X-ray source is a laser-plasma X-ray source.

3. An X-ray generator according to Claim 1, wherein the X-ray source is a discharge-plasma X-ray source.

4. An X-ray generator according to any preceding claim, wherein the portion of the inner surfaces is coated with carbon.

5. An X-ray generator according to Claim 4, wherein the carbon is selected from the group consisting of carbon black, benzene soot, fullerene, carbon nanotubes, and dried suspensions of colloidal graphite

6. An X-ray generator according to any one of Claims 1 to 3, wherein the portion of the inner surfaces comprises a porous material.

7. An X-ray generator according to Claim 6, wherein the porous material is selected from the group consisting of activated charcoal and porous silicon.

8. An X-ray generator according to any one of Claims 1 to 3, wherein the portion of the inner surfaces comprises anodized aluminum.

9. An X-ray generator, wherein the portion of the inner surfaces comprises a brushy layer.

10. An X-ray generator according to Claim 9, wherein the brushy layer comprises multiple needle-shaped members extending from the inner wall toward the plasma.

11. An X-ray generator according to Claim 10, wherein the needles have respective tapered tips extending toward the plasma.

12. An X-ray generator according to Claim 9, wherein the brushy layer comprises multiple bristle-shaped or blade-shaped members.

13. An X-ray generator according to Claim 9, wherein the brushy layer is a carpet of glass fibres or bristles, carbon fibres or bristles, metal fibres or bristles, or silicon fibres or bristles, or combinations thereof.

14. An X-ray generator according to any preceding claim, further comprising a cooling mechanism for cooling the vacuum chamber.

15. An X-ray generator, comprising:
an X-ray source in which a plasma is produced from a target material and X-rays are emitted from the plasma; and
a vacuum chamber defined by walls and containing the X-ray source, at least a portion of the walls being made of a material that is transmissive to incident electromagnetic radiation, from the plasma, in a wavelength range from infrared to ultraviolet, the portion representing a location from which the electromagnetic radiation otherwise would reflect back into the vacuum chamber and heat a component situated inside the vacuum chamber.

16. An X-ray generator according to Claim 15, wherein the portion is made of a glass material selected from the group consisting of conventional glass, quartz glass, MgF₂, and CaF_{2.}

17. An X-ray generator according to Claim 15 or 16, wherein the portion includes an anti-reflective coating applied to the glass material.

18. An X-ray generator, comprising:
an X-ray source in which a plasma is produced from a target material and X-rays are emitted from the plasma; and
a vacuum chamber defined by walls and containing the X-ray source, at least a portion of the walls being made of a material that is substantially ureflective to incident electromagnetic radiation, from the plasma, in a wavelength range from infrared to ultraviolet, the portion representing a location from which the electromagnetic radiation otherwise would reflect back into the vacuum chamber and heat a component situated inside the vacuum chamber.

19. An X-ray microlithography system, comprising:
an X-ray generator according to any preceding claim;
an illumination-optical system situated and configured to direct an X-ray illumination beam from the X-ray generator onto a pattern-defining reticle, thereby forming a patterned beam carrying an aerial image of the pattern; and
a projection-optical system situated and configured to project the patterned beam from the reticle to form an image on a sensitive substrate.
